(19) Europäisches Patentamt
European Patent Office
Office européen des brevets

(11) **EP 3 417 305 B1**

(12) **EUROPÄISCHE PATENTSCHRIFT**

(45) Veröffentlichungstag und Bekanntmachung des Hinweises auf die Patenterteilung:
**20.01.2021 Patentblatt 2021/03**

(21) Anmeldenummer: **17705884.9**

(22) Anmeldetag: **17.02.2017**

(51) Int Cl.:
*G01R 31/382* (2019.01)       *G01R 35/00* (2006.01)
*G01R 1/20* (2006.01)        *G01R 19/00* (2006.01)

(86) Internationale Anmeldenummer:
**PCT/EP2017/053664**

(87) Internationale Veröffentlichungsnummer:
**WO 2017/140874 (24.08.2017 Gazette 2017/34)**

(54) **BATTERIESENSOR, VERFAHREN ZUM KALIBRIEREN EINES MESSWIDERSTANDS UND VERWENDUNG**

BATTERY SENSOR, METHOD FOR CALIBRATING A SHUNT RESISTOR AND USE

CAPTEUR DE BATTERIE, PROCÉDÉ POUR ÉTALONNER UNE RESISTANCE DE MESURE ET UTILISATION ASSOCIÉE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.02.2016 DE 102016202500**

(43) Veröffentlichungstag der Anmeldung:
**26.12.2018 Patentblatt 2018/52**

(73) Patentinhaber: **Continental Automotive GmbH 30165 Hannover (DE)**

(72) Erfinder:
• **FRENZEL, Henryk**
**93059 Regensburg (DE)**
• **SCHRAMME, Martin**
**86343 Königsbrunn (DE)**

(56) Entgegenhaltungen:
**DE-A1- 10 310 503**       **DE-A1-102007 020 502**
**DE-A1-102011 006 304**    **US-A1- 2006 267 592**
**US-A1- 2013 214 804**     **US-A1- 2015 048 839**
**US-A1- 2015 137 820**

**Beschreibung**

Die Erfindung betrifft einen Batteriesensor, ein Verfahren zum Kalibrieren eines Messwiderstands und eine zugehörige Verwendung.

Batteriesensoren werden in zahlreichen elektronischen oder elektrischen Produkten eingesetzt, in welchen es nötig ist, Ströme exakt zu ermitteln bzw. zu messen. Ein derartiges Messen von Strömen kann über verschiedene bekannte Vorgehensweisen erfolgen, beispielsweise über den Hall-Effekt oder mittels eines Messwiderstands, welcher auch als Shunt-Widerstand bezeichnet werden kann. Im letzteren Fall wird die Stromstärke typischerweise über den Spannungsabfall am Messwiderstand ermittelt, welcher bei einem Stromfluss durch den Messwiderstand realisiert wird. Ein solcher Messwiderstand weist typischerweise geringe Toleranzen, insbesondere hinsichtlich der Temperatur, und einen geringen Drift über eine typische Produktlebensdauer auf.

Im Bereich der Automobilindustrie werden derartige Batteriesensoren typischerweise eingesetzt, um den Zustand einer Autobatterie zu überwachen. Dabei wird normalerweise auch ein Stromfluss von der Batterie zum Chassis überwacht.

In der US 2006/267592 A1 ist beispielsweise ein solcher Sensor gezeigt, wobei mehrere Messwiderstände parallel geschaltet werden können, und eine Messung eines Spannungsabfalls über die Messwiderstände erfolgen kann. In der US 2013/214804 A1 ist ein Sensor gezeigt, bei dem der Spannungsabfall über Feldeffekttransistoren gemessen wird. In der US 2015/137820 A1 ist ein Sensor gezeigt, bei dem die über mehrere Widerstände abfallende Spannung gemessen wird. In der DE 10 2011 006304 A1 ist ein Sensor beschrieben, bei dem zur Bestimmung von Offsetfehlern des Sensors ein elektrisches Mittel parallel zum Stromsensor geschaltet wird, wobei zeitweise ein Strom bekannter Größe über die elektrischen Mittel geleitet werden kann.

In einem solchen Batteriesensor wird typischerweise ein Strom von einer Batterieklemme zum Chassis gemessen. Beispielsweise stellt ein Schraubbolzen ein Interface zu einem Kabel dar, welches wiederum mit dem Fahrzeugchassis verbunden ist. Innerhalb eines solchen Batteriesensors ist typischerweise der Messwiderstand sowohl mechanisch als auch elektrisch platziert. Um die notwendige Temperatur- und Langzeitstabilität sicherzustellen, ist es typischerweise erforderlich, für den Messwiderstand ein spezielles Material mit entsprechenden Eigenschaften zu verwenden. Beispielsweise kann eine Kupfer-Nickel-Mangan-Legierung, welche insbesondere unter dem Namen Manganin bekannt ist, verwendet werden. Diese ist jedoch sehr teuer und auch schwer zu verarbeiten. Alternativ ist es auch bekannt, dass Messungen ohne einen hochstabilen Messwiderstand durchgeführt werden, wobei in diesem Fall typischerweise eine Temperaturkompensation und/oder ständiger elektrischer Abgleich zu erfolgen hat.

Bei im Stand der Technik bekannten Systemen kann beispielsweise periodisch ein Strompuls erzeugt werden, welcher zusätzlich zum zu messenden Laststrom über den zu messenden Messwiderstand geleitet wird. Die Größe des Strompulses wird vor dem Zusammenführen mit dem Laststrom bestimmt, beispielsweise indem der Spannungsabfall an einem ausreichend präzisen, bekannten Referenzwiderstand gemessen wird.

Die Summe aus dem Referenzstrom und dem zu messenden Laststrom erzeugt nun an dem zu bestimmenden Messwiderstand einen entsprechenden Spannungspuls, der mit ausreichender Auflösung gemessen und ausgewertet wird. Der Wert des Messwiderstands ergibt sich aus dem Wert des Referenzwiderstands und dem Verhältnis der gemessenen Spannungspulse am Messwiderstand und am Referenzwiderstand. Nachteilig an dieser Lösung ist jedoch, dass ein zusätzlicher Strompuls zu erzeugen ist. Dieser soll im Verhältnis zum Laststrom eine ausreichend hohe Stromstärke haben, um mit der erforderlichen Auflösung detektierbar zu sein. Diese hohe Stromstärke führt je nach Pulsdauer und -häufigkeit zu einem merklichen Anstieg des durchschnittlichen Gesamtstromverbrauchs des Batteriesensorsystems, was wiederum zu einer Belastung der Fahrzeugbatterie durch den Ruhestrom führt.

Es ist deshalb eine Aufgabe der Erfindung, einen im Vergleich zum Stand der Technik alternativen, insbesondere verbesserten Batteriesensor vorzusehen. Es ist des Weiteren eine Aufgabe der Erfindung, ein zugehöriges Verfahren und eine zugehörige Verwendung bereitzustellen.

Dies wird erfindungsgemäß durch einen Batteriesensor nach Anspruch 1 und ein Verfahren nach Anspruch 9 erreicht. Vorteilhafte Ausgestaltungen können beispielsweise den jeweiligen Unteransprüchen entnommen werden. Der Inhalt der Ansprüche wird durch ausdrückliche Inbezugnahme zum Inhalt der Beschreibung gemacht.

Die Erfindung betrifft einen Batteriesensor.

Der Batteriesensor weist einen Batterieanschluss auf.

Der Batteriesensor weist einen Kabelanschluss zur Verbindung mit einem Fahrzeug auf.

Der Batteriesensor weist einen Messwiderstand mit einem ersten Pol und einem zweiten Pol auf, wobei der erste Pol mit dem Batterieanschluss verbunden ist und der zweite Pol mit dem Kabelanschluss verbunden ist.

Der Batterieanschluss weist zumindest einen Referenzwiderstand auf, welcher über einen Schalter ganz oder teilweise zum Messwiderstand parallelgeschaltet werden kann.

Des Weiteren weist der Batteriesensor einen ersten Spannungsmessanschluss auf, welcher mit dem ersten Pol des Messwiderstands verbunden ist, und weist außerdem einen zweiten Spannungsmessanschluss auf, welcher mit dem zweiten Pol des Messwiderstands verbunden ist.

Der Batteriesensor weist ferner eine elektrische Steuerung auf. Diese ist dazu konfiguriert, den oder die Schalter während eines Kalibrierzeitraums alternierend zu öffnen und zu schließen. Der Kalibrierzeitraum kann auf verschiedene Weise festgesetzt oder bestimmt werden, beispielsweise wie dies weiter unten beschrieben wird.

Die elektronische Steuerungsvorrichtung ist dazu konfiguriert, basierend auf einer gemessenen, über dem Messwiderstand abfallenden Spannung bei geschlossenem Schalter und einer gemessenen, über dem Messwiderstand abfallenden Spannung bei offenem Schalter sowie einem Widerstandswert des Referenzwiderstandes einen Widerstandswert des Messwiderstands zu berechnen. Dies erlaubt eine vorteilhafte Bestimmung des Stroms bzw. der abfallenden Spannung, ohne dass hierfür ein besonders genauer Messwiderstand erforderlich wäre.

Mittels des erfindungsgemäßen Batteriesensors kann ein anderes, noch nicht bekanntes Verfahren bzw. eine Vorgehensweise zur Stromstärkenmessung verwendet werden. Dabei wird der Strom einmal nur durch den Messwiderstand geleitet und periodisch auch durch den Referenzwiderstand geleitet. Mittels des bei Parallelschaltung des Referenzwiderstands gemessenen Spannungsabfalls kann auf die Stromstärke geschlossen werden.

Der Batterieanschluss dient insbesondere zum Anschluss an einen Pol einer Batterie, insbesondere einer Autobatterie, wobei insbesondere mit einem Masse- bzw. Minuspol der Batterie verbunden wird, jedoch auch mit einem Pluspol verbunden werden kann.

Der Kabelanschluss dient insbesondere dazu, ein Kabel zum Verbinden mit der Chassis eines Fahrzeugs anzuschließen. Es sei jedoch erwähnt, dass auch ein Anschluss, welcher direkt an die Chassis eines Fahrzeugs oder an eine sonstige Masse oder Referenzspannung angeschlossen werden kann, im Rahmen dieser Anmeldung als Kabelanschluss zu verstehen ist.

Der Messwiderstand weist vorteilhaft einen Widerstandswert zwischen 0, 05 mOhm und 0, 15 mOhm, insbesondere bevorzugt 0,1 mOhm auf. Der Referenzwiderstand weist bevorzugt einen Widerstandswert zwischen 1 mOhm und 10 mOhm auf. Derartige Werte haben sich in der Praxis als vorteilhaft erwiesen. Insbesondere kann durch den angegebenen Wert des Messwiderstands typischen Einsatzsituationen Rechnung getragen werden, in welchen hohe Ströme von mehreren Hundert oder auch Tausend Ampere durch den Messwiderstand fließen müssen, beispielsweise beim Starten eines Motors mittels eines elektrischen Anlassers. Außerdem kann durch den gewählten Wert des Referenzwiderstands, welcher insbesondere größer bzw. deutlich größer ist als der Messwiderstand, ein gut zu messender Spannungsabfall erreicht werden.

Gemäß einer Weiterbildung weist der Batteriesensor eine Mehrzahl von Referenzwiderständen auf, welche über einem jeweiligen Schalter ganz oder teilweise zum Messwiderstand parallelgeschaltet werden können. Damit kann das beschriebene Prinzip verfeinert werden, beispielsweise können für unterschiedliche Spannungs-, Strom- und/oder Temperaturbereiche unterschiedliche Referenzwiderstände vorgesehen werden. Es sei jedoch erwähnt, dass auch lediglich ein Referenzwiderstand vorhanden sein kann.

Die elektronische Steuerungsvorrichtung kann vorteilhaft dazu konfiguriert sein, Kalibrierzeiträume festzulegen, insbesondere auf Zeiten, in welchen sich ein durch den Messwiderstand fließender Strom innerhalb eines vorgegebenen Bereichs befindet. Dabei handelt es sich vorteilhaft um einen vorgegebenen Bereich, in welchem besonders gute Messungen durchgeführt werden können. Der fließende Strom kann beispielsweise periodisch ermittelt oder aufgrund von Betriebsparametern eines Fahrzeugs geschätzt werden.

Die Kalibrierzeiträume können insbesondere auch so gelegt werden, dass die Kalibrierzeiträume nicht auf Zeiten fallen, in welchen eine besonders hohe Stromlast durch den Messwiderstand fließt, beispielsweise weil gerade ein Anlasser eines Motors betätigt wird. Dies reduziert die thermische Belastung des Referenzwiderstands und sorgt zudem für bessere Messergebnisse.

Gemäß einer bevorzugten Ausführung weist der Batteriesensor eine Spannungsmesseinrichtung auf, welche mit dem ersten Spannungsmessanschluss und dem zweiten Spannungsmessanschluss verbunden ist und welche ferner zur Datenübertragung mit der elektronischen Steuerungsvorrichtung verbunden ist. Dies erlaubt eine Integration der Spannungsmesseinrichtung in den Batteriesensor. Es sei jedoch verstanden, dass die Spannungsmesseinrichtung auch unabhängig von dem Vorhandensein einer elektronischen Steuerungsvorrichtung vorhanden sein kann. Des Weiteren sei verstanden, dass auch eine externe Spannungsmesseinrichtung verwendet werden kann, welche dann typischerweise entsprechend mit den Spannungsmessanschlüssen verbunden ist.

Die Erfindung betrifft des Weiteren ein Verfahren zum Kalibrieren eines Messwiderstands, welches folgende Schritte aufweist:

- Messen einer über dem Messwiderstand abfallenden ersten Spannung ohne parallel geschalteten Referenzwiderstand,
- Messen einer über dem Messwiderstand abfallenden zweiten Spannung mit parallel geschaltetem Referenzwiderstand, und
- Berechnen eines Widerstandswertes des Messwiderstands abhängig von der ersten Spannung, der zweiten Spannung und einem Widerstandswert des Referenzwiderstands.

Mittels des erfindungsgemäßen Verfahrens kann das weiter oben bereits mit Bezug auf die beschriebene Vorrichtung erläuterte Messprinzip vorteilhaft umgesetzt werden. Bezüglich der damit verbundenen Vorteile sei auf die obige Beschreibung verwiesen.

Der Referenzwiderstand kann insbesondere durch Schließen eines Schalters parallelgeschaltet werden. Dementsprechend kann die Parallelschaltung typischerweise auch durch Öffnen des Schalters beendet werden.

Der Schritt des Berechnens kann beispielsweise auch basierend auf einem Widerstandswert des Messwiderstands ausgeführt werden.

Das Verfahren kann insbesondere in kurzen Abständen hintereinander durchgeführt werden. Entsprechend können jeweilige Messzyklen gelegt werden. Man geht typischerweise davon aus, dass während der Messung der zu messende Strom als konstant angesehen werden kann. Es kann eine Bewertung innerhalb eines Algorithmus dem Verfahren nachgeschaltet, sein, welcher das Ergebnis bzw. das Kalibrationsergebnis, insbesondere den Widerstandswert, als glaubhaft einstuft oder verwirft.

Das Verfahren kann insbesondere mittels eines erfindungsgemäßen Batteriesensors durchgeführt werden, wobei auf alle beschriebenen Ausführungen und Varianten zurückgegriffen werden kann. Erläuterte Vorteile gelten entsprechend. Insbesondere sei erwähnt, dass alle mit Bezug auf den beschriebenen Batteriesensor erwähnten Merkmale auch bezüglich des erfindungsgemäßen Verfahrens anwendbar sind. Das Gleiche gilt in umgekehrter Richtung.

Ein Unterschied zwischen der ersten Spannung und der zweiten Spannung beträgt vorteilhaft zwischen 0,5 % und 1,5 %, besonders bevorzugt 1 %. Dies hat sich in der Praxis als vorteilhaft erwiesen.

Ein Unterschied zwischen der ersten Spannung und der zweiten Spannung beträgt vorteilhaft zwischen 50 $\mu$V und 150 $\mu$V, besonders bevorzugt 100 $\mu$V. Auch dies hat sich als vorteilhaft erwiesen.

Es ist bevorzugt, dass der zumindest eine Referenzwiderstand, welcher ganz oder teilweise zum Messwiderstand parallelgeschaltet werden kann, als parallel schaltbarer Leistungshalbleiter, insbesondere als Transistor, ausgebildet ist.

Besonders bevorzugt kann der Schalter bei als Leistungshalbleiter ausgebildetem Referenzwiderstand entfallen, da Leistungshalbleiter bei entsprechend angelegter Spannung, insbesondere bei entsprechend angelegter Gate-Source-Spannung, gesperrt werden und/oder im Wesentlichen in einen nicht leitenden Zustand geschaltet werden können.

Es ist bevorzugt, dass wenigstens eine erste Diodenstrecke des Leistungshalbleiters als Referenzwiderstand genutzt wird.

Besonders bevorzugt wird unter Diodenstrecke ein p-n und/oder ein n-p Übergang verstanden.

Besonders bevorzugt wird unter Diodenstrecke ein Material-übergang in Halbleiterkristallen zwischen Bereichen mit entgegengesetzter Dotierung verstanden, insbesondere Bereiche, in denen die Dotierung von negativ (n) zu positiv (p) und/oder von positiv (p) zu negativ (n) wechselt.

Besonders bevorzugt ist der Leistungshalbleiter als Thyristor oder als Transistor oder als Diode oder als Bipolartransistor oder als Feldeffekttransistor ausgebildet.

Bevorzugt wird anhand einer Kennlinie, insbesondere einer Strom-Spannungs-Kennlinie, des Leistungshalbleiters bzw. des Transistors anhand von erfassten Parametern ein Widerstandswert des Leistungshalbleiters bzw. des Transistors ermittelt. Dabei wird insbesondere zumindest eine Temperatur des Leistungshalbleiters bzw. des Transistors ermittelt und/oder zumindest eine Spannung über eine zweite Diodenstrecke des Leistungshalbleiters bzw. des Transistors erfasst und/oder die zumindest eine Spannung über der zweiten Diodenstrecke des Leistungshalbleiters bzw. des Transistors auf einen definierten Wert geregelt.

Bevorzugt wird über dem Leistungshalbleiter eine Spannung gemessen, wobei anhand der gemessenen Spannung und eines Widerstandswertes des Leistungshalbleiters, ein durch den Leistungshalbleiter fließender Strom ermittelt wird.

Bei dem erfindungsgemäßen Batteriesensor ist vorteilhaft die elektronische Steuerungsvorrichtung dazu ausgebildet, ein erfindungsgemäßes Verfahren durchzuführen. Dabei kann auf alle beschriebenen Ausführungen und Varianten sowohl hinsichtlich des Batteriesensors wie auch hinsichtlich des Verfahrens zurückgegriffen werden. Die Steuerungsvorrichtung kann insbesondere Speichermittel und Prozessormittel aufweisen, wobei in den Speichermitteln Programmcode gespeichert ist, bei dessen Ausführung die Prozessormittel ein entsprechendes Verfahren ausführen bzw. sich entsprechend verhalten.

Die Erfindung betrifft des Weiteren die Verwendung eines zeitweise parallel geschalteten Referenzwiderstands zum Kalibrieren eines Messwiderstands eines Batteriesensors. Damit können die weiter oben beschriebenen Vorteile erreicht werden.

Die Verwendung kann insbesondere mittels eines erfindungsgemäßen Batteriesensors und/oder mittels eines erfindungsgemäßen Verfahrens durchgeführt werden. Dabei kann auf alle beschriebenen Ausführungen und Varianten sowohl hinsichtlich des Batteriesensors wie auch hinsichtlich des Verfahrens zurückgegriffen werden.

Allgemeiner formuliert wird vorgeschlagen, dass aus einem Laststrom ein Strompuls abgezweigt wird. Durch Parallelschaltung eines präzisen Referenzwiderstands zum Messwiderstand wird kurzzeitig ein Teil des Laststroms über den Referenzwiderstand geleitet.

Der Spannungsabfall am Messwiderstand sinkt entsprechend dem abgezweigten Strompuls, während am Referenzwiderstand die Höhe des Pulses bestimmt wird. Aus dem Verhältnis des Spannungseinbruchs am Messwiderstand und der Pulshöhe am Referenzwiderstand und dem Wert des Referenzwiderstands kann der Wert des Messwiderstands berechnet werden.

Dies hat den Vorteil, dass die Batteriesensorschaltung keinen zusätzlichen Strompuls erzeugen muss und damit wird der durchschnittliche Gesamtstromverbrauch klein gehalten.

Für die Generierung der bekannten Veränderung sind verschiedene Schaltungssysteme vorstellbar.

Es sei verstanden, dass der Referenzwiderstand auch veränderbar ausgelegt werden kann, so dass dieser optimal an den aktuell fließenden Strom durch den Messwiderstand angepasst werden kann. Hierzu kann beispielsweise ein veränderlicher Widerstand, beispielsweise in Form eines Potentiometers, oder eine schaltbare Parallelschaltung von Widerständen verwendet werden. Es kann auch ein allgemeineres Widerstandsnetzwerk oder eine andere entsprechende Anordnung verwendet werden.

Bevorzugt wird an dem Referenzwiderstand eine Spannung zur Messung des durch den Referenzwiderstand fließenden Stroms erfasst.

Bevorzugt ist der Referenzwiderstand so ausgebildet ist, dass zumindest innerhalb eines definierten Messbereichs des Batteriesensors der elektrische Widerstand des Referenzwiderstands abnimmt, wenn der Strom durch den Referenzwiderstand zunimmt und/oder dass der elektrische Widerstand des Referenzwiderstands zunimmt, wenn der Strom durch den Referenzwiderstand abnimmt.

Bevorzugt liegt der Ausbildung des Batteriesensors die Anforderung zu Grunde, dass die geforderte Auflösung von deltaI/deltaBit bis auf einen Proportionalitätsfaktor - kleiner ist als der maximale Messfehler e. Dabei ist deltaI die Änderung des zu messenden Stroms durch den wenigstens einen Referenzwiderstand und deltaBit das Messauflösungsquantum definiert durch einen nachgeschalteten Analog-Digital-Wandler. Der maximale Messfehler e soll dabei konstant bzw. jederzeit höchstens p% vom jeweiligen Messwert betragen, beispielsweise unter 1% bleiben. Im Folgenden wird aus diesen Anforderungen anhand der folgenden Gleichungen beispielhaft ein gewünschter bzw. idealer Zusammenhang zwischen Messspannung und Messstrom theoretisch hergeleitet:

$$\text{geforderte Auflösung}: \frac{\Delta I}{\Delta D} = p\% \cdot I = p\% \cdot I_{\max} \cdot \frac{D}{2^n - 1} \quad \Rightarrow (1): \Delta I = p\% \cdot I_{\max} \cdot \frac{D}{2^n - 1} \Delta D$$

$$(2): \frac{D}{\left(2^n - 1\right)} = \frac{U_{AD}}{U_{AD\max}};$$

$$(3): \Delta D = \frac{\Delta U_{AD}}{U_{AD\max}} \cdot \left(2^n - 1\right)$$

$$(2),(3) \rightarrow (1) => (4): \Delta I = p\% \cdot I_{\max} \cdot \frac{U_{AD}}{U_{AD\max}^2} \cdot \left(2^n - 1\right) \cdot \Delta U_{AD}$$

$$(4) \xrightarrow{\Delta \rightarrow \partial} (5): \partial I = p\% \cdot I_{\max} \cdot \frac{U_{AD}}{U_{AD\max}^2} \cdot \left(2^n - 1\right) \partial U_{AD}$$

$$(6): I = p\% \cdot \frac{I_{\max}}{U_{AD\max}^2} \cdot \left(2^n - 1\right) \int_0^{U_{sense}} U_{AD} \, \partial U_{AD}$$

$$(7): I = p\% \cdot \frac{I_{\max}}{U_{AD\max}^{2}} \cdot \frac{2^{n}-1}{2} \cdot U_{sense}^{2} = p\% \cdot k \cdot U_{sense}^{2}$$

$$(8): U_{sense} = \sqrt{\frac{I}{p\% \cdot k}}$$

mit:

$I_{max}$ : maximaler Messstrom
n : Bitbreite AD-Wandler
D : AD gewandelter Messwert [LSB]
$U_{AD}$ : AD-Wandler Eingangsspannung
$U_{ADmax}$ : maximaler AD Wandlungsbereich
$U_{sense}$ : aktuelle Messspannung

Aus der zweckmäßigen Forderung einer prozentual konstanten Auflösung ergibt sich idealerweise ein zumindest quadratischer Zusammenhang zwischen Messspannung und zu messendem Strom, welcher bevorzugt auch durch eine antiproportionale Funktion bzw. eine 1/x-Funktion zwischen Messspannung und Messstrom angenähert werden kann, durch eine entsprechende Auslegung des Referenzwiderstands.

Der Batteriesensor ist vorzugsweise so ausgebildet, dass die prozentuale Auflösung der Strommessung bezogen auf den aktuellen Wert des Stroms bzw. den aktuellen Messstrom durch den Referenzwiderstand zumindest über den definierten Messbereich des Batteriesensors im Wesentlichen konstant bleibt.

Der Batteriesensor umfasst bevorzugt mindestens einen Regelkreis, mit welchem die Spannung über dem Referenzwiderstand auf einen definierten Referenzspannungswert eingeregelt wird, zumindest innerhalb eines definierten Messbereichs.

Vorzugsweise ist der Batteriesensor so ausgebildet, dass die definierte Referenzspannung zur Messbereichserweiterung einstellbar ist.

Der Batteriesensor weist zur Bereitstellung der wenigstens einen Referenzspannung zweckmäßigerweise zumindest eine Referenzspannungsquelle auf.

Der Referenzwiderstand umfasst vorzugsweise mindestens ein Transistorelement, insbesondere wenigstens einen Feld-Effekt-Transistor, besonders bevorzugt zumindest einen MOSFET. Zur Messung des durch den Referenzwiderstand fließenden Stroms wird zweckmäßigerweise die Gate-Source-Spannung bzw. Basis-Emitter-Spannung an dem Transistorelement erfasst.

Der definierte Messbereich des Messstroms umfasst vorzugsweise mindestens vier Zehnerpotenzen, insbesondere wenigstens fünf Zehnerpotenzen.

Bei geregelter Spannung über dem Referenzwiderstand ist vorzugsweise der Widerstandswert des Referenzwiderstands im Wesentlichen abhängig von 1 durch den Wert des Stroms durch den Referenzwiderstand oder im Wesentlichen abhängig von 1 durch die Wurzel aus dem Wert des Stroms durch den Referenzwiderstand.

Der wenigstens eine Referenzwiderstand umfasst vorzugsweise zwei oder mehr parallel geschaltete Teilwiderstandselemente, welche zu- und/oder abschaltbar ausgebildet sind zur Messbereichserweiterung, wobei diese Teilwiderstandselemente insbesondere in den Regelkreis integriert sind.

Es ist bevorzugt, dass der Batteriesensor zumindest ein Temperaturmesselement aufweist, welches die Temperatur des wenigstens einen Referenzwiderstands erfasst, wobei diese Temperatur bei der Messung des durch den mindestens einen Referenzwiderstand fließenden Stroms berücksichtigt wird, insbesondere durch eine Berechnung in wenigstens einer Signalverarbeitungseinheit des Batteriesensors.

Es ist zweckmäßig, dass der Batteriesensor einen ersten und einen zweiten Regelkreis umfasst, mit welchen jeweils die Spannung über einem Referenzwiderstand auf einen definierten Referenzspannungswert eingeregelt wird, zumindest innerhalb eines definierten Messbereichs, wobei der Referenzwiderstand des ersten Regelkreises von dem zu messenden Strom mit einer ersten definierten Richtung durchflossen werden kann und der Referenzwiderstand des zweiten Regelkreises von dem zu messenden Strom mit einer zweiten, zur ersten Richtung entgegengesetzten Richtung durchflossen werden kann und der zu messende Strom je nach Stromrichtung mittels des ersten Regelkreises oder mittels des zweiten Regelkreises erfasst und gemessen wird. Die Referenzspannungswerte des ersten und zweiten Regelkreises sind insbesondere unterschiedlich einstellbar. Es ist bevorzugt, dass die Referenzwiderstände des ersten und zweiten Regelkreises als zwei zueinander komplementär ausgebildete Feldeffekttransistoren ausgebildet sind und/oder dass die Referenzwiderstände des ersten und zweiten Regelkreises parallel geschaltet sind und dabei der Drainanschluss oder Kollektoranschluss des einen Referenzwiderstands jeweils mit dem Sourceanschluss oder Emitteranschluss des anderen Referenzwiderstands verbunden ist, insbesondere wechselseitig.

Dem wenigstens einen Referenzwiderstand ist vorzugsweise zumindest ein SenseFET zugeordnet, welcher mit einem Analog-Digital-Wandler verbunden ist, wobei mittels des SenseFETs der Strom durch den Referenzwiderstand bestimmt wird.

Zumindest der SenseFET und der zugeordnete Referenzwiderstand sind zweckmäßigerweise gemeinsam auf einem Chip ausgebildet.

Besonders bevorzugt ist die Gate-Source-Spannung bzw. Basis-Emitter-Spannung des SenseFETs gleich der Gate-Source-Spannung bzw. Basis-Emitter-Spannung des zugeordneten Referenzwiderstands ausgeprägt.

Zweckmäßigerweise weist der Quotient aus dem Wert des Drain-Source-Widerstands bzw. Kollektor-Emitter-Widerstands des SenseFETs zu dem Wert des Drain-Source-Widerstands bzw. Kollektor-Emitter-Widerstands des zugeordneten Referenzwiderstands einen definierten Wert auf. Insbesondere ist eine Referenzspannungsquelle oder Referenzstromquelle mit dem SenseFET verbunden, wodurch der Temperatureinfluss der Strommessung im Wesentlichen unterdrückt werden kann.

Unter einer Auflösung wird vorzugsweise eine definierte Mindestmessgenauigkeit verstanden. Zweckmäßigerweise umfasst der wenigstens eine Regelkreis mindestens einen Verstärker als Stellglied.

Der wenigstens eine Referenzwiderstand ist vorzugsweise als Regelstrecke seines Regelkreises ausgebildet, wobei insbesondere die Drain-Source-Spannung bzw. Kollektor-Emitter-Spannung über dem Referenzwiderstand die Regelgröße bildet und die Gate-Source-Spannung bzw. Basis-Emitter-Spannung an dem Referenzwiderstand die Stellgröße, aus welcher direkt oder indirekt der Messstrom bzw. der Wert des Stroms durch den Referenzwiderstand berechnet wird.

Es ist bevorzugt, dass die Drain-Source-Spannung bzw. Kollektor-Emitter-Spannung über dem wenigstens einen Transistorelement, als der zumindest eine Referenzwiderstand, von mindestens einem Regelkreis auf einen konstanten, durch eine Referenzspannungsquelle bestimmten Wert, eingeregelt wird, unabhängig vom Strom, der durch den Referenzwiderstand fließt. Das heißt, der Referenzwiderstand arbeitet als geregelter Widerstand.

Außerdem bezieht sich die Erfindung auch auf die Verwendung des Batteriesensors in Kraftfahrzeugen, insbesondere zur Messung eines Ent- und/oder Aufladestroms eines elektrischen Energiespeichers in einem Elektro- oder Hybridfahrzeug.

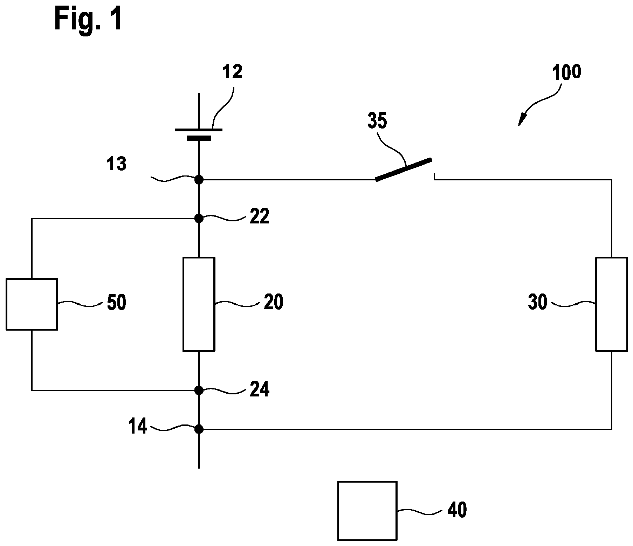

Weitere Merkmale und Vorteile wird der Fachmann dem nachfolgend mit Bezug auf die beigefügte Zeichnung beschriebenen Ausführungsbeispiel entnehmen. Dabei zeigt Fig. 1 einen Batteriesensor.

Fig. 1 zeigt einen Batteriesensor 100 gemäß einem ersten Ausführungsbeispiel der Erfindung,

Fig. 2 zeigt einen Batteriesensor 100 gemäß einem zweiten Ausführungsführungsbeispiel der Erfindung,

Fig. 3 zeigt einen Batteriesensor 100 gemäß einem dritten Ausführungsführungsbeispiel der Erfindung,

Fig. 4 eine beispielhafte Veranschaulichung des Regelkreises des Referenzwiderstands, und

Fig. 5 ein Ausführungsbeispiel, bei welchem der Referenzwiderstand parallel geschaltete und dabei zu- und abschaltbare Teilwiderstandselemente umfasst zur Messbereichserweiterung.

Der Batteriesensor 100 ist an eine Batterie 12 angeschlossen. Hierzu weist der Batteriesensor 100 einen Batterieanschluss 13 auf. Des Weiteren weist der Batteriesensor 100 einen Kabelanschluss 14 auf, mit welchem der Batteriesensor 100 an eine nicht dargestellte Fahrzeugchassis angeschlossen werden kann.

Zwischen dem Batterieanschluss 13 und dem Kabelanschluss 14 ist ein Messwiderstand 20 verschaltet. Dieser hat vorliegend einen Widerstandswert von 0,1 mOhm. Unmittelbar an den Polen des Messwiderstands 20 sind ein erster Spannungsmessanschluss 22 und ein zweiter Spannungsmessanschluss 24 angeordnet, um die über dem Messwiderstand 20 abfallende Spannung zu messen.

Parallel zum Messwiderstand 20 ist ein Referenzwiderstand 30 geschaltet. Dabei ist ein Schalter 35 vorgesehen, mit welchem die Parallelschaltung aktiviert bzw. unterbrochen werden kann. Ist der Schalter 35 geschlossen, so ist der Referenzwiderstand 30 parallel zum Messwiderstand 20 geschaltet. Ist der Schalter 35 hingegen offen, so ist der Referenzwiderstand 30 nicht parallel zum Messwiderstand 20 geschaltet.

Der Batteriesensor 100 weist des Weiteren eine lediglich schematisch dargestellte elektronische Steuerungsvorrichtung 40 auf. Diese ist dazu ausgebildet, geeignete Messzeiträume zu ermitteln, wobei dies anhand von Fahrzeugdaten erfolgt, welche die elektronische Steuerungsvorrichtung 40 erhält. Insbesondere legt die elektronische Steuerungsvorrichtung 40 Messzeiträume nicht auf Zeiten, in welchen ein Anlasser eines Fahrzeugs in Betrieb ist.

Während jeweiligen Messzeiträumen schließt und öffnet die elektronische Steuerungsvorrichtung 40 den Schalter 35 periodisch. Dadurch wird der Referenzwiderstand 30 abwechselnd mit dem Messwiderstand 20 parallelgeschaltet oder auch nicht. Anders ausgedrückt wird der von der Batterie 12 kommende Strom entweder durch beide Widerstände 20, 30 oder nur durch den Messwiderstand 20 geleitet.

Zum Messen der über dem Messwiderstand 20 abfallenden Spannung ist des Weiteren eine Spannungsmesseinrichtung 50 vorgesehen. Dies ist mit den beiden Spannungsmessanschlüssen 22, 24 verbunden und misst somit die über dem Messwiderstand 20 abfallende Spannung. Die Spannungsmesseinrichtung 50 ist auch zur Datenübertragung mit der elektronischen Steuerungsvorrichtung 40 verbunden, was nicht näher dargestellt ist.

Anhand von Spannungen, welche von der Spannungsmesseinrichtung 50 während einer Parallelschaltung einerseits und während einem alleinigen Stromfluss durch den Messwiderstand 20 andererseits gemessen wurden, kann die elektronische Steuerungsvorrichtung 40 anhand der bekannten Widerstandswerte den Stromfluss durch den Messwiderstand 20 ermitteln. Dies entspricht einer typischen Funktionalität eines Batteriesensors.

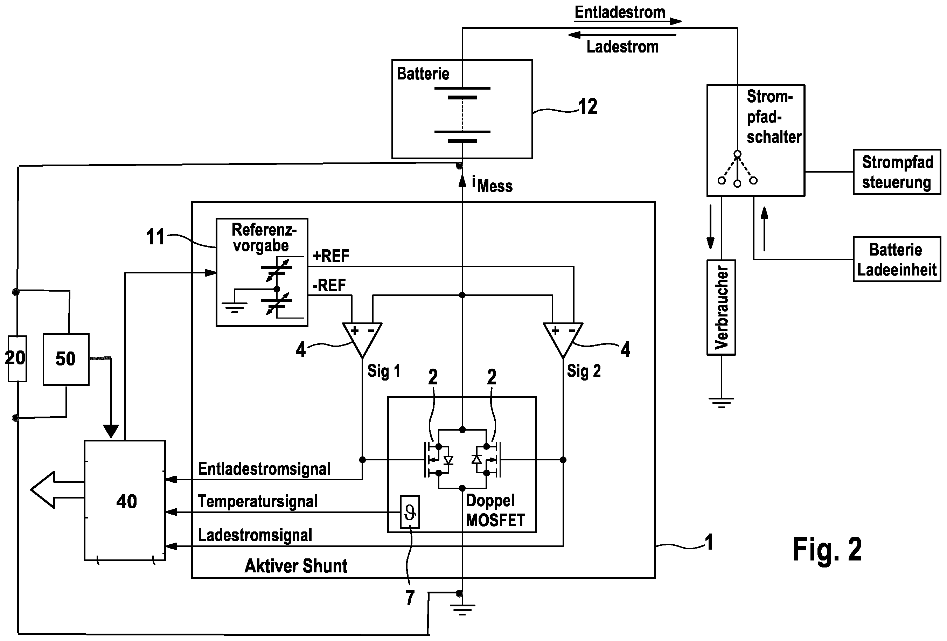

Fig. 2 zeigt ein Ausführungsbeispiel des Batteriesensors 100, der zur Messung des Entlade- und Ladestroms eines elektrischen Energiespeichers bzw. Batterie 12 benutzt wird. Batteriesensor 100 umfasst dabei einen zu bzw. abschaltbaren Referenzwiderstandszweig 1. Der Referenzwiderstandszweig umfasst einen ersten und einen zweiten Regelkreis, wobei der erste Regelkreis den linken Referenzwiderstand 2, den linken Verstärker 4 bzw. Sig1 sowie die diesem zugeordnete Referenzspannungswertvorgabe der Referenzspannungsquelle 11 umfasst, und der zweite Regelkreis den rechten Referenzwiderstand 2, den rechten Verstärker 4 bzw. Sig2 und die entsprechende Referenzspannungswertvorgabe umfasst. Die beiden Referenzwiderstände der beiden Regelkreise werden von dem im Referenzwiderstandszweig 1 zu messenden Strom $i_{Mess}$ bei aktiviertem Referenzwiderstandszweig 1 durchflossen, wobei der Referenzwiderstand des ersten Regelkreises beim Entladen von Strom durchflossen wird und der Referenzwiderstand des zweiten Regelkreises beim Laden, also wenn Messstrom $i_{Mess}$ die entgegengesetzte Fließrichtung aufweist. Die Referenzwiderstände 2 des ersten und zweiten Regelkreises sind beispielgemäß als zwei zueinander komplementär ausgebildete MOS-Feldeffekttransistoren ausgebildet und parallel geschaltet, wobei der Drainanschluss des einen Referenzwiderstands jeweils mit dem Sourceanschluss des anderen Referenzwiderstands wechselseitig verbunden ist. Die Drain-Source-Spannung der beiden MosFETs wird dabei auf einen definierten Referenzspannungswert eingeregelt, wodurch der Widerstandswert der beiden Referenzwiderstände im Wesentlichen abhängig von 1 durch den Wert des Stroms $i_{Mess}$ durch den Referenzwiderstand ausgeprägt ist und somit bei steigendem Messstrom $i_{Mess}$ der Widerstandswert abnimmt und bei abnehmendem Strom der Widerstandswert des Referenzwiderstands 2 zunimmt. Zur Messung des Stroms wird dabei die Gate-Source-Spannung des entsprechenden Referenzwiderstands erfasst, welche die Stellgröße des ersten und zweiten Regelkreises ist und dem Analog-Digital-Wandler zugeführt wird. Referenzwiderstandszweig 1 weist außerdem ein Temperaturmesselement 7 auf, das die Temperatur $\vartheta$ der beiden Referenzwiderstände 2 erfasst, wobei diese Temperatur bei der Berechnung des Messstroms in der Signalverarbeitungseinheit 40 berücksichtigt wird.

Insbesondere kann der Schalter 35 bei als Leistungshalbleiter ausgebildetem Referenzwiderstand entfallen, da Leistungshalbleiter bei entsprechend angelegter Spannung, insbesondere bei entsprechend angelegter Gate-Source-Spannung, gesperrt werden und/oder im Wesentlichen in einen nicht leitenden Zustand geschaltet werden können.

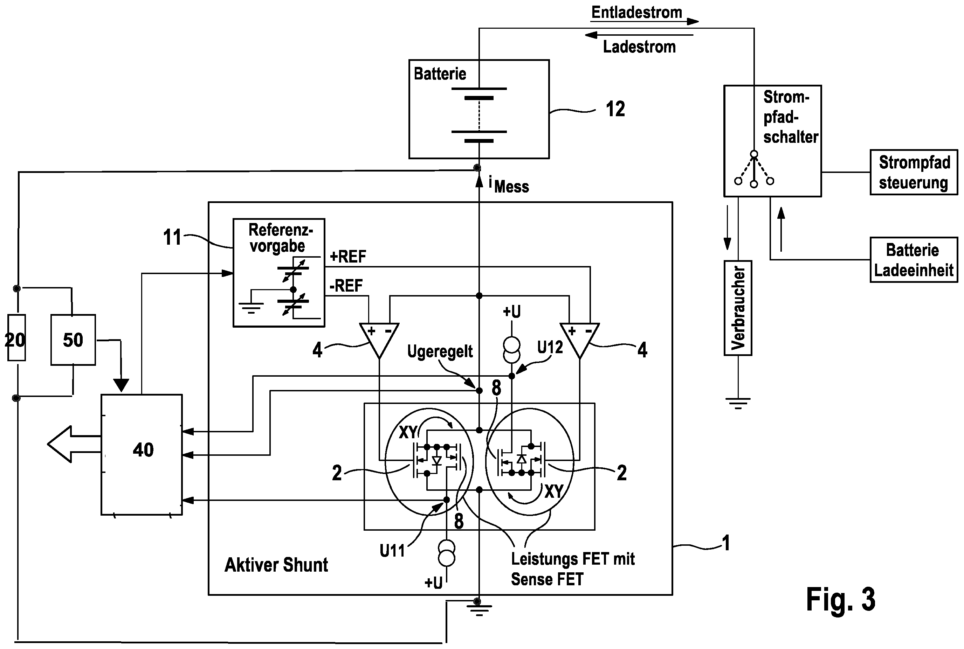

In Fig. 3 ist ein Ausführungsbeispiel veranschaulicht, das ausgehend vom Referenzwiderstandszweig 1 aus Fig.2 den MosFET-Referenzwiderständen der beiden Regelkreise jeweils einen zugeordneten SenseFET 8 umfasst. Also beiden LeistungsFETs als Referenzwiderständen 2 ist noch jeweils ein SENSE-FET zugeordnet, welcher mit Analog-Digital-Wandler verbunden ist, wobei mittels des SenseFETs der Strom durch den Referenzwiderstand 2 bestimmt wird. Die Gate-Source-Spannung des SenseFETs ist jeweils gleich der Gate-Source-Spannung des zugeordneten Referenzwiderstands bzw. LeistungsFETs ausgeprägt. Der Quotient aus dem Wert des Drain-Source-Widerstands des SenseFETs zu dem Wert des Drain-Source-Widerstands des zugeordneten Referenzwiderstands weist einen definierten Wert X/Y auf. Dieser Wert X/Y kann dabei für jeden Pfad unterschiedlich sein (X1/Y1 - X2/Y2). Das Verhältnis dieser beiden Widerstandswerte bzw. -wertepaare ist nahezu temperaturunabhängig und lässt sich sehr genau herstellen. Die beiden SENSE-FETs werden über zwei getrennte Stromquellen mit einem stabilen, präzisen Strom beaufschlagt. Misst man nun die Spannungen U11 bzw. U12 und dividiert diese durch den bekannten Strom der Stromquellen, so erhält man den eingeregelten Widerstandswert der Leistungs FETs dividiert durch den Teilungsfaktor X/Y. Durch Multiplikation mit der gemessenen Spannung Ugeregelt erhält man den Strom $i_{Mess}$, der durch die LeistungsFETs bzw. Referenzwiderstände 2 fließt.

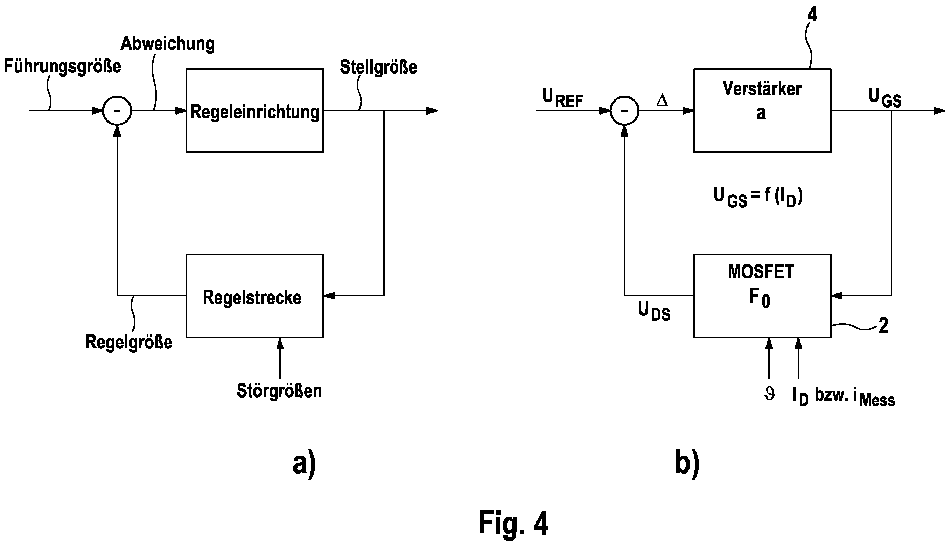

Fig. 4 a) zeigt einen schematischen Regelkreis, dem gegenübergestellt anhand der Fig. 4 b) ein beispielhafter Regelkreis des Referenzwiderstandszweigs erläutert wird. Der Referenzspannungswert $U_{REF}$ ist die Führungsgröße. In Verstärker 4, der als Reglereinheit und Stelleinrichtung ausgebildet ist, wird die Stellgröße $U_{GS}$ als Gate-Source-Spannung bereitgestellt, die über dem Referenzwiderstand anliegend eingeregelt wird. Der Referenzwiderstand 2 selbst bildet die Regelstrecke, welche durch den Messstrom $i_{Mess}$ sowie die Temperatur $\vartheta$ beeinflusst wird. Aus der Regelgröße $U_{DS}$ als Drain-Source-Spannung des Referenzwiderstands wird Messstrom $i_{Mess}$ berechnet.

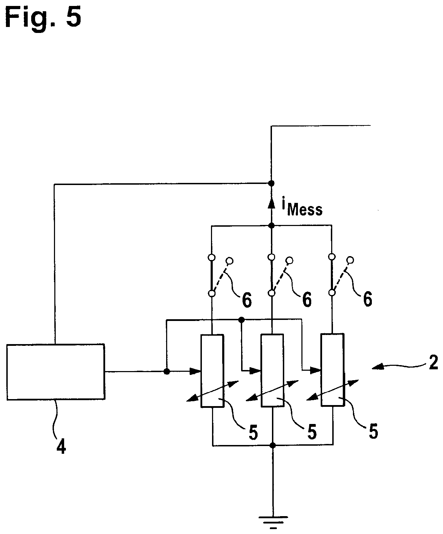

Anhand der Fig. 5 ist eine Ausführungsform veranschaulicht, bei der Referenzwiderstand 2 drei parallel geschaltete Teilwiderstandselemente 5 umfasst, welche durch Referenzwiderstabdsschalter 6 zu- und abschaltbar ausgebildet sind zur Messbereichserweiterung. Die Teilwiderstandselemente 5 werden von Verstärker 4, als Reglereinheit und Stelleinrichtung, angesteuert.

Erwähnte Schritte des erfindungsgemäßen Verfahrens können in der angegebenen Reihenfolge ausgeführt werden. Sie können jedoch auch in einer anderen Reihenfolge ausgeführt werden. Das erfindungsgemäße Verfahren kann in einer seiner Ausführungen, beispielsweise mit einer bestimmten Zusammenstellung von Schritten, in der Weise ausgeführt werden dass keine weiteren Schritte ausgeführt werden. Es können jedoch grundsätzlich auch weitere Schritte ausgeführt werden, auch solche welche nicht erwähnt sind.

**Patentansprüche**

1.   Batteriesensor (100), aufweisend

- einen Batterieanschluss (13),
- einen Kabelanschluss (14) zur Verbindung mit einem Fahrzeug,
- einen Messwiderstand (20) mit einem ersten Pol und einem zweiten Pol, wobei der erste Pol mit dem Batterieanschluss (13) verbunden ist und der zweite Pol mit dem Kabelanschluss (14) verbunden ist,
- zumindest einen Referenzwiderstand (30), welcher über einen Schalter (35) ganz oder teilweise zum Messwiderstand (20) parallelgeschaltet werden kann,
- einen ersten Spannungsmessanschluss (22), welcher mit dem ersten Pol des Messwiderstands (20) verbunden ist, und
- einen zweiten Spannungsmessanschluss (24), welcher mit dem zweiten Pol des Messwiderstands (20) verbunden ist, **dadurch gekennzeichnet, dass**
der Batteriesensor ferner eine elektronische Steuerungsvorrichtung (40) aufweist, welche dazu konfiguriert ist, den oder die Schalter (35) während eines Kalibrierzeitraums alternierend zu öffnen und zu schließen, und die elektronische Steuerungsvorrichtung (40) dazu konfiguriert ist, basierend auf einer gemessenen, über dem Messwiderstand (20) abfallendenden Spannung bei geschlossenem Schalter (35) und einer gemessenen, über dem Messwiderstand (20) abfallenden Spannung bei offenem Schalter (35) sowie einem Widerstandswert des Referenzwiderstandes (30) einen Widerstandswert des Messwiderstands (20) zu berechnen.

2.   Batteriesensor (100) nach Anspruch 1, wobei

- der Messwiderstand (20) einen Widerstandswert zwischen 0,05 mOhm und 0,15 mOhm, bevorzugt 0,1 mOhm, aufweist;
und/oder
- der Referenzwiderstand (30) einen Widerstandswert zwischen 1 mOhm und 10 mOhm aufweist.

3.   Batteriesensor (100) nach einem der vorhergehenden Ansprüche, welcher

- eine Mehrzahl von Referenzwiderständen aufweist, welche über einen jeweiligen Schalter (35) ganz oder teilweise zum Messwiderstand (20) parallelgeschaltet werden können.

4.   Batteriesensor (100) nach einem der vorhergehenden Ansprüche, wobei

- die elektronische Steuerungsvorrichtung (40) dazu konfiguriert ist, Kalibrierzeiträume festzulegen, insbesondere auf Zeiten, in welchen sich ein durch den Messwiderstand (20) fließender Strom innerhalb eines vorgegebenen Bereichs befindet.

5.   Batteriesensor (100) nach einem der vorhergehenden Ansprüche, wobei

- der Batteriesensor (100) eine Spannungsmesseinrichtung (50) aufweist, welche mit dem ersten Spannungsmessanschluss (22) und dem zweiten Spannungsmessanschluss (22) verbunden ist und welche ferner zur Datenübertragung mit der elektronischen Steuerungsvorrichtung (40) verbunden ist.

6.   Batteriesensor (100) nach einem der Ansprüche 1 bis 5, wobei der zumindest eine Referenzwiderstand (30), an welchem eine Spannung (UGS) zur Messung des durch den Referenzwiderstand (30) fließenden Stroms (iMess) erfasst wird, so ausgebildet ist, dass zumindest innerhalb eines definierten Messbereichs des Batteriesensors der elektrische Widerstand des Referenzwiderstands abnimmt, wenn der Strom (iMess) durch den Referenzwiderstand zunimmt.

**7.** Batteriesensor (100) nach einem der Ansprüche 1 bis 6, wobei der zumindest eine Referenzwiderstand (30), welcher ganz oder teilweise zum Messwiderstand (20) parallelgeschaltet werden kann, als parallel schaltbarer Leistungshalbleiter, insbesondere als Transistorelement und/oder Feld-Effekt-Transistor, ausgebildet ist.

**8.** Batteriesensor (100) nach Anspruch 6 und/oder 7, wobei wenigstens eine Diodenstrecke des Leistungshalbleiters als Referenzwiderstand genutzt wird.

**9.** Verfahren zum Kalibrieren eines Messwiderstands (20), welches folgende Schritte aufweist:

- Messen einer über dem Messwiderstand (20) abfallenden ersten Spannung ohne parallelgeschalteten Referenzwiderstand (30),
- Messen einer über dem Messwiderstand (20) abfallenden zweiten Spannung mit parallelgeschaltetem Referenzwiderstand (30), und
- Berechnen eines Widerstandswerts des Messwiderstands (20) abhängig von der ersten Spannung, der zweiten Spannung und einem Widerstandswert des Referenzwiderstands (30).

**10.** Verfahren nach Anspruch 9, wobei

- der Referenzwiderstand (30) durch Schließen eines Schalters (35) parallelgeschaltet wird.

**11.** Verfahren nach einem der Ansprüche 9 oder 10,

- welches mittels eines Batteriesensors (100) nach einem der Ansprüche 1 bis 10 durchgeführt wird.

**12.** Verfahren nach einem der Ansprüche 9 bis 11,

- wobei ein Unterschied zwischen der ersten Spannung und der zweiten Spannung zwischen 0,5 % und 1,5 %, bevorzugt 1 %, beträgt.

**13.** Verfahren nach einem der Ansprüche 9 bis 12,

- wobei ein Unterschied zwischen der ersten Spannung und der zweiten Spannung zwischen 50 $\mu$V und 150 $\mu$V, bevorzugt 100 $\mu$V, beträgt.

**Claims**

**1.** Battery sensor (100) having

- a battery connection (13),
- a cable connection (14) for connection to a vehicle,
- a measurement resistor (20) having a first pole and a second pole, wherein the first pole is connected to the battery connection (13) and the second pole is connected to the cable connection (14),
- at least one reference resistor (30) which can be completely or partially connected in parallel with the measurement resistor (20) via a switch (35),
- a first voltage measurement connection (22) which is connected to the first pole of the measurement resistor (20), and
- a second voltage measurement connection (24) which is connected to the second pole of the measurement resistor (20),
**characterized in that**
the battery sensor also has an electronic control apparatus (40) which is configured to alternately open and close the switch(es) (35) during a calibration period, and
the electronic control apparatus (40) is configured to calculate a resistance value of the measurement resistor (20) on the basis of a measured voltage dropped across the measurement resistor (20) when the switch (35) is closed and a measured voltage dropped across the measurement resistor (20) when the switch (35) is open and a resistance value of the reference resistor (30).

2. Battery sensor (100) according to Claim 1, wherein

- the measurement resistor (20) has a resistance value between 0.05 mohm and 0.15 mohm, preferably 0.1 mohm; and/or
- the reference resistor (30) has a reference resistance value between 1 mohm and 10 mohm.

3. Battery sensor (100) according to one of the preceding claims, which

- has a plurality of reference resistors which can be completely or partially connected in parallel with the measurement resistor (20) via a respective switch (35).

4. Battery sensor (100) according to one of the preceding claims, wherein

- the electronic control apparatus (40) is configured to define calibration periods, in particular at times at which a current flowing through the measurement resistor (20) is within a predefined range.

5. Battery sensor (100) according to one of the preceding claims, wherein

- the battery sensor (100) has a voltage measurement device (50) which is connected to the first voltage measurement connection (22) and to the second voltage measurement connection (22) and is also connected to the electronic control apparatus (40) for the purpose of transmitting data.

6. Battery sensor (100) according to one of Claims 1 to 5, wherein the at least one reference resistor (30), at which a voltage (UGS) for measuring the current (iMess) flowing through the reference resistor (30) is captured, is designed in such a manner that, at least within a defined measurement range of the battery sensor, the electrical resistance of the reference resistor decreases if the current (iMess) through the reference resistor increases.

7. Battery sensor (100) according to one of Claims 1 to 6, wherein the at least one reference resistor (30), which can be completely or partially connected in parallel with the measurement resistor (20), is in the form of a power semiconductor which can be switched in a parallel manner, in particular in the form of a transistor element and/or a field effect transistor.

8. Battery sensor (100) according to Claim 6 and/or 7, wherein at least one diode path of the power semiconductor is used as the reference resistor.

9. Method for calibrating a measurement resistor (20), which has the following steps of:

- measuring a first voltage dropped across the measurement resistor (20) without a reference resistor (30) connected in parallel,
- measuring a second voltage dropped across the measurement resistor (20) with a reference resistor (30) connected in parallel, and
- calculating a resistance value of the measurement resistor (20) on the basis of the first voltage, the second voltage and a resistance value of the reference resistor (30).

10. Method according to Claim 9, wherein

- the reference resistor (30) is connected in parallel by closing a switch (35).

11. Method according to either of Claims 9 and 10,

- which is carried out by means of a battery sensor (100) according to one of Claims 1 to 10.

12. Method according to one of Claims 9 to 11,

- wherein a difference between the first voltage and the second voltage is between 0.5% and 1.5%, preferably 1%.

**13.** Method according to one of Claims 9 to 12,

- wherein a difference between the first voltage and the second voltage is between 50 $\mu$V and 150 $\mu$V, preferably 100 $\mu$V.

**Revendications**

**1.** Capteur de batterie (100), comportant

- une borne de batterie (13),
- une borne de câble (14) pour la connexion à un véhicule,
- une résistance de mesure (20) comprenant un premier pôle et un second pôle, dans lequel le premier pôle est relié à la borne de batterie (13) et le second pôle est relié à la borne de câble (14),
- au moins une résistance de référence (30), qui peut être montée entièrement ou partiellement en parallèle avec la résistance de mesure (20) par l'intermédiaire d'un commutateur (35),
- une première borne de mesure de tension (22), qui est reliée au premier pôle de la résistance de mesure (20), et
- une seconde borne de mesure de tension (24), qui est reliée au second pôle de la résistance de mesure (20),
**caractérisé en ce que**
le capteur de batterie comporte en outre un dispositif de commande électronique (40) qui est configuré pour ouvrir et pour fermer en alternance le ou les commutateurs (35) pendant une période d'étalonnage, et le dispositif de commande électronique (40) est configuré pour calculer une valeur de résistance de la résistance de mesure (20) sur la base d'une tension mesurée chutant aux bornes de la résistance de mesure (20) lorsque le commutateur (35) est fermé et d'une tension mesurée chutant aux bornes de la résistance de mesure (20) lorsque le commutateur (35) est ouvert, ainsi que d'une valeur de résistance de la résistance de référence (30).

**2.** Capteur de batterie (100) selon la revendication 1, dans lequel

- la résistance de mesure (20) présente une valeur de résistance comprise entre 0,05 mOhm et 0,15 mOhm, de préférence de 0,1 mOhm ;
et/ou
- la résistance de référence (30) présente une valeur de résistance comprise entre 1 mOhm et 10 mOhm.

**3.** Capteur de batterie (100) selon l'une des revendications précédentes, qui

- comporte une pluralité de résistances de référence qui peuvent être montées entièrement ou partiellement en parallèle avec la résistance de mesure (20) par l'intermédiaire d'un commutateur respectif (35).

**4.** Capteur de batterie (100) selon l'une des revendications précédentes, dans lequel

- le dispositif de commande électronique (40) est configuré pour fixer des périodes d'étalonnage, en particulier à des instants où un courant passant à travers la résistance de mesure (20) se situe dans une plage prédéterminée.

**5.** Capteur de batterie (100) selon l'une des revendications précédentes, dans lequel

- le capteur de batterie (100) comporte un dispositif de mesure de tension (50) qui est relié à la première borne de mesure de tension (22) et à la seconde borne de mesure de tension (22) et qui est en outre relié au dispositif de commande électronique (40) pour la transmission de données.

**6.** Capteur de batterie (100) selon l'une des revendications 1 à 5, dans lequel ladite au moins une résistance de référence (30), au niveau de laquelle est détectée une tension (UGS) servant à mesurer le courant (iMess) passant à travers la résistance de référence (30), est conçue de manière à ce qu'au moins dans une plage de mesure définie du capteur de batterie, la résistance électrique de la résistance de référence diminue lorsque le courant (iMess) passant à travers la résistance de référence augmente.

**7.** Capteur de batterie (100) selon l'une des revendications 1 à 6, dans lequel ladite au moins une résistance de référence (30), qui peut être montée entièrement ou partiellement en parallèle avec la résistance de mesure (20), est réalisée sous la forme d'un semi-conducteur de puissance pouvant être monté en parallèle, en particulier sous la forme d'un élément à transistor et/ou d'un transistor à effet de champ.

8. Capteur de batterie (100) selon la revendication 6 et/ou 7, dans lequel au moins un trajet de diode du semi-conducteur de puissance est utilisé en tant que résistance de référence.

9. Procédé d'étalonnage d'une résistance de mesure (20), comprenant les étapes consistant à :

   - mesurer une première tension chutant aux bornes de la résistance de mesure (20) sans résistance de référence (30) montée en parallèle,
   - mesurer une seconde tension chutant aux bornes de la résistance de mesure (20) avec une résistance de référence (30) montée en parallèle, et
   - calculer une valeur de résistance de la résistance de mesure (20) en fonction de la première tension, de la seconde tension et d'une valeur de résistance de la résistance de référence (30).

10. Procédé selon la revendication 9, dans lequel

    - la résistance de référence (30) est montée en parallèle par fermeture d'un commutateur (35).

11. Procédé selon l'une des revendications 9 ou 10,

    - qui est mis en œuvre au moyen d'un capteur de batterie (100) selon l'une des revendications 1 à 10.

12. Procédé selon l'une des revendications 9 à 11,

    - dans lequel une différence entre la première tension et la seconde tension est comprise entre 0,5 % et 1,5 %, et est de préférence de 1 %.

13. Procédé selon l'une des revendications 9 à 12,

    - dans lequel la différence entre la première tension et la seconde tension est comprise entre 50 $\mu$V et 150 $\mu$V, et est de préférence de 100 $\mu$V.

# Fig. 1

EP 3 417 305 B1

Fig. 2

15

Fig. 3

**a)**

Führungsgröße

Abweichung

Regeleinrichtung

Stellgröße

Regelstrecke

Regelgröße

Störgrößen

**b)**

$U_{REF}$

$\Delta$

**Verstärker**
**a** — 4

$U_{GS}$

$U_{GS} = f(I_D)$

$U_{DS}$

**MOSFET**
**$F_0$**

2

$\vartheta$   $I_D$ bzw. $i_{Mess}$

**Fig. 4**

EP 3 417 305 B1

# Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2006267592 A1
- US 2013214804 A1
- US 2015137820 A1
- DE 102011006304 A1